# EUROPEAN PATENT APPLICATION

(11) **EP 2 966 677 A1**
(43) Date of publication of application: **13.01.2016**
(21) Application number: 14176028.0
(22) Date of filing: 07.07.2014
(51) Int. Cl.: H01L 21/60, H01L 23/495, H01L 21/48

(54) **Method of attaching electronic components by soldering with removal of substrate oxide coating using a flux, corresponding substrate and corresponding flip-chip component**

(71) Applicant: NXP B.V., 5656 AG Eindhoven (NL)
(72) Inventor: Walczyk,, Sven, Redhill, Surrey RH1 1SH (GB); de Beer,, Johan Rene, Redhill, Surrey RH1 1SH (GB); Eltink,, Erik, Redhill, Surrey RH1 1SH (GB); Mavinkurve,, Amar, Redhill, Surrey RH1 1SH (GB)
(74) Representative: Miles, John Richard

(57) **Abstract**

A method of attaching an electronic component (202) to a metal substrate (204) such as a lead frame, wherein the electronic component (202) comprises an exposed solder region comprising a solder bump (206) and flux (208) thereon, the method comprising: forming a metal-based compound layer (210) (a metal oxide, metal sulphide or metal nitride layer) on the metal substrate (204); placing the electronic component (202) on the metal substrate (204) such that the solder region is in contact with a contact region of the metal-based compound layer (210); and heating the solder region such that the contact region of the metal-based compound layer (210) dissolves under the influence of the flux (208) and the reflowed solder bump (206) forms an electrical connection between the electronic component (202) and the metal substrate (204). The metal-based compound layer (210) can have a minimum thickness of 10 nm. The provision of the metal-based compound layer (210) on the metal substrate (204) may prevent or reduce excessive flow-out of flux (208) and/or solder (206) during heating in the reflow process.

## Description

This disclosure relates to methods of attaching electronic components to a metal substrate, and in particular, although not exclusively, methods of attaching flip-chip components (both active and passive) to leadframes.

According to a first aspect there is provided a method of attaching an electronic component to a metal substrate, wherein the electronic component comprises solder provided on an exposed solder region, the method comprising:
forming a metal-based compound layer on the substrate, wherein the metal-based compound layer has a minimum thickness of 10 nm;
placing the electronic component on the metal substrate such that the solder region is in contact with a contact region of the metal-based compound layer; and
heating the solder region such that the contact region of the metal-based compound layer dissolves and the solder region forms an electrical connection between the electronic component and the metal substrate.

The provision of the metal-based compound layer on the substrate may prevent or reduce excessive flow-out of flux and/or solder during heating, which provides a reflow process, in comparison to the case where flux or solder is applied directly to the substrate.

The metal-based compound layer may have a minimum thickness of 10, 20 or 25 nm. The metal-based compound layer may have a maximum thickness of 40, 50, 100, 250, 500 nm or 1 micron. The metal-based compound may have a thickness between 20 and 50 nm.

The step of forming the metal-based compound layer on the substrate may comprise exposing the metal substrate to a reactive gas. The reactive gas may comprise one or more of oxygen, nitrogen and sulphur. The reactive gas may be at a pressure of 1 atmosphere. The reactive gas may be a component of a mixture of gases with a pressure of 1 atmosphere.

Forming the metal-based compound layer on the substrate may comprise exposing the metal substrate to the reactive gas at a temperature in the range of 50⁰C to 250⁰C, and in particular 150⁰C to 250⁰C or 175⁰C to 250⁰C. Forming the metal-based compound layer on the substrate may comprise exposing the metal substrate to a reactive gas, optionally within one of the above temperature ranges, for a predetermined period of time in the range of 5 to 60 minutes, and in particular 15 to 30 minutes, or a period of 5 minutes or more.

The solder region may comprise a portion of flux. The portion of flux may be situated on an exposed portion of the solder region. The solder may be provided between the flux and an electrical contact of the electronic component. The method may comprise heating the solder region such that the flux dissolves the contact region of the metal-based compound layer. The electronic component may be a flipped component.

The metal-based compound layer may have a lower surface energy than the metal substrate. The metal-based compound layer may be a ceramic. The metal-based compound layer may comprise one or more of be a metal oxide layer, a metal nitride layer or a metal sulphide layer. The metal oxide layer may comprises Cu₂O and/or CuO. A majority of the oxide layer measured by weight may be composed of Cu₂O and/or CuO.

The metal substrate may be an alloy substrate. The alloy substrate may comprise steel. The metal substrate may comprise one or more of copper, aluminium, iron, chromium and nickel.

According to a further aspect of the invention there is provided an apparatus configured to perform any method described herein.

According to a further aspect of the invention there is provided a substrate for receiving an electronic component comprising solder provided on a solder region, the substrate comprising:
a metal substrate for electrically connecting to the electronic component; and
a metal-based compound layer over the metal substrate, wherein the metal-based compound layer has a minimum thickness of 10 nm,
wherein the metal-based compound layer is configured to be dissolved upon contact with the solder region when the solder region is molten such that the solder region forms an electrical connection between the electronic component and the metal substrate.

The substrate may be a leadframe. The metal-based compound layer may have a lower surface energy than the metal substrate.

According to a further aspect of the invention there is provided a flip-chip component comprising the substrate described herein.

Embodiments of the invention will now be described by way of example, and with reference to the enclosed drawings in which:
Figure 1 a shows a first component arrangement after flux, solder and component placement, but before reflow;
Figure 1b shows the component arrangement of figure 1 a after reflow;
Figure 2a shows a second component arrangement after flux, solder and component placement, but before reflow;
Figure 2b shows the component arrangement of figure 2a after reflow;
Figure 3 shows four examples of how an amount of flux / solder flow-out varies with a level of oxidation applied to a metal substrate; and
Figure 4 illustrates schematically a method of attaching an electronic component to a metal substrate.

Examples disclosed herein relate to attaching electronic components to a metal substrate, such as the assembly of flipped components, such as flipped-chip components, to substrates or leadframes. Such flip-chipped components will be referred to below as flip chips for convenience. Flip chip packages may be referred to as having a controlled collapse chip connection method for interconnecting semiconductor devices to external circuitry. A flip chip may have solder bumps / copper pillars / soldercaps that have been deposited onto pads of the flip chip, thereby providing an exposed solder region (a region for providing solder which is exposed). The solder bumps / copper pillars / soldercaps can be deposited on the chip pads on the top side of the wafer during a wafer processing step.

In order to mount the flip chip to a substrate (for example, a leadframe, a circuit board, a substrate, or another chip or wafer), it can be flipped over so that its top side faces down, and aligned so that its solder regions align with matching pads on the external circuit. The solder can then be reflowed to complete the electrical connection.

Reducing cost and reducing defects, for example to implement a "zero-defect" quality program, can be desirable.

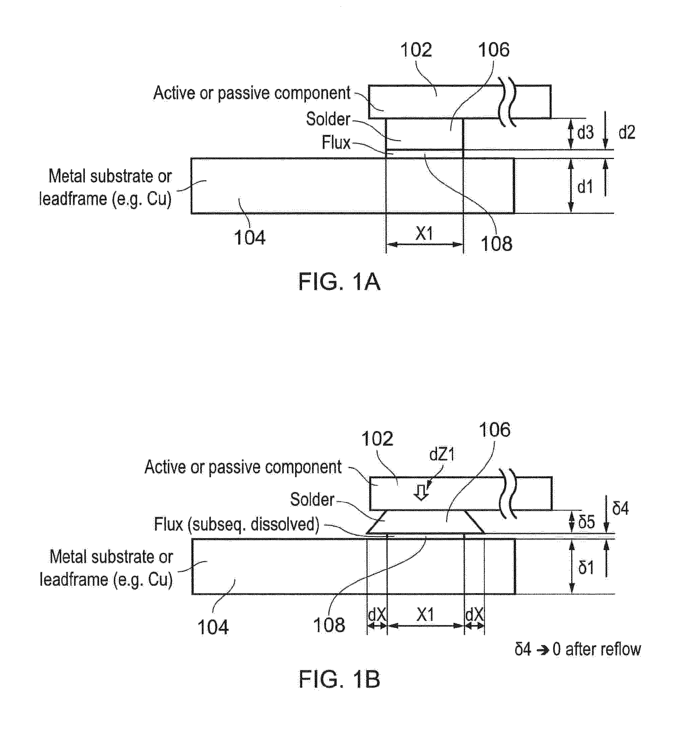

Figures 1a and 1b show how an active or passive electronic component, in this example a flip chip 102, can be electrically and mechanically connected to a metal substrate 104. Figure 1a shows the component arrangement after flux, solder and component placement, but before reflow. Figure 1b shows the component arrangement after flux, solder and component placement, and after reflow.

It will be appreciated that the electronic component may be any die or other type of component. The metal substrate 104 may also be referred to as a lead frame, and can be made out of copper, for example. The metal substrate 104 may be a track or a pad on a circuit board such as a printed circuit board (PCB).

The flip chip 102 shown in figure 1a has a solder bump 106 connected to it. The solder bump 106 and flux 108 have a width (in a dimension that is parallel to the plane of the metal substrate 104) of X1 before they are reflowed. The solder bump 106 is in electrical contact with a contact pad (not shown) within the flip chip. As is well-known in the art, the solder bump 106 is associated with a volume of flux 108, which is schematically shown between the solder bump 106 and the metal substrate 104 for ease of illustration. The flux 108 can enable the solder bump 106 to flow easily when it is heated and can also reduce or prevent oxidation of the metal substrate to which the flip chip 102 is to be connected. The flux 108 has a thickness (in a dimension that is perpendicular to the plane of the metal substrate 104) of d2 and the solder bump has a thickness of d3 before the solder is reflowed.

Figure 1b shows the component arrangement after the solder bump 106 has been reflowed. Heating and reflowing the solder bump 106 and the flux 108 when the flip chip 102 is adjacent to the metal substrate 104 can make use of flux- and subsequent solder attachment in order to mechanically and electrically connect the flip chip 102 to the metal substrate 104. In this way, a first level (package internal) interconnect from the flip chip 102 to the metal substrate 104 is formed. However since the viscosity of the flux 108 can change as a function of temperature and time, especially when the surface of the metal substrate 104 is clean, the flux location can deviate from its original position and flow or creep along the surface of the metal substrate 104 such that a spot of solder attachment to the metal substrate 104 is wider than the initial solder spot size of the solder bump 106. This wider spot can, however, lead to an inhomogeneous reflow performance resulting in increased assembly failures, because the flux size might vary along the surface of the metal substrate 104.

As shown in figure 1b, the width of the flux 108, and also the solder that is in contact with the metal substrate 104 increases from X1 (as it was in figure 1a before reflow) to "X1 + 2dX" during the reflow process, where dX is the lateral expansion of the flux 108 and solder bump 106 on opposing sides of the solder bump 106. For illustrative purposes only, the lateral expansion dX of the flux 108 and solder bump 106 on opposing sides of the solder bump 106 is assumed to be the same, although in practice this will not necessarily be the case.

As a result of the lateral expansion, the solder surface area on the metal substrate 104 also increases. The flux 108 will eventually dissolve, that is, its thickness δ4 will tend to zero, which will result in the height of the flip chip 102 above the metal substrate 104 also decreasing. This is shown in figure 1b as the component height (dZ1) shrinking. This reduction in height is a function of the change in flux 108 and solder bump 106 size while forming the interconnection during the reflow process. The individual flow-out of the flux 108 can also depend on the surface area / footprint of the solder bump 106 that contacts the metal substrate 104, the amount of flux, and also a surface condition of the metal substrate 102 at the position of the subsequent interconnection. Any in-homogeneity along the discrete interconnections could lead to placement errors such as the flip chip 102 drifting to one side or tilting (delta Z) or rotation (delta XY), and subsequently lead to product failures.

Also, as the width of the solder bump 106 increases during reflow and the height of the flip chip 102 above the metal substrate 104 decreases, any unevenness in these changes for different solder bumps on the same flip chip 102 can result in the flip chip 102 tilting relative to the metal substrate 104, which can be undesirable, and can also lead to failures.

Flux and solder size variations on the metal substrate 104 can be reduced or minimized by using solder masks having holes in which the solder is intended to be restricted. However, such solder masks can involve additional cost. Also, such a solder mask can create another challenge of delamination-free adhesion of this solder mask layer to an encapsulant, particularly for metalized substrates. Such an encapsulant can be an electrical insulator, such as an epoxy, that is moulded around the solder bumps after the flip chip 102 has been attached to the substrate 104.

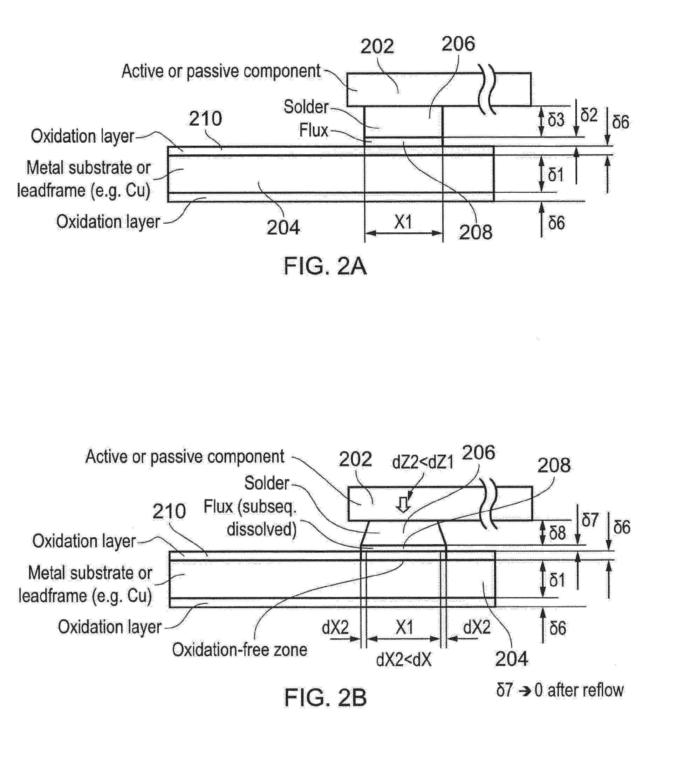

Figures 2a and 2b show how an active or passive electronic component, in this example a flip chip 202, can be electrically and mechanically connected to a metal substrate 204 in an improved way. Figure 2a shows the component arrangement after flux, solder and component placement, but before reflow. Figure 2b shows the component arrangement after flux, solder and component placement, and after reflow.

Figures 2a and 2b are used to describe how an electronic component (in this example a flip chip 202) is attached to a metal substrate 204. As with figures 1 a and 1b, the flip chip has an exposed solder region comprising a solder bump 206 and a portion of flux 208 in this example.

As shown in figures 2a and 2b, a metal-based compound layer 210 has been formed on the metal substrate before the flip chip 202 and its associated solder bump 206 have been brought into contact with the metal substrate 204. That is, before reflowing, there is a layer of metal-based compound 210 located between the solder bump 206 / flux 208 and the metal substrate 204.

In this example the metal-based compound layer is a metal oxide layer 210, which can be formed by pre-oxidizing the metal substrate 204 to form a layer of metal oxide layer 210 on the metal substrate 204. The metal oxide layer 210 (which may be, for example a combination of CuO and Cu₂O) is shown to have a thickness of δ6, which can be considered as thin when compared with the thickness of the metal substrate 204 (δ1). The metal oxide layer 210 may be have a thickness greater than about 10 or 20 nm. Improved adherence between the metal oxide layer 210 and a copper substrate may also be achieved when the oxide thickness is less than about 50 nm. The oxide morphology and internal stresses in thicker oxide layers can increase the risk of delamination of the solder joint due to fracture of the oxide. Where a thick oxide is grown (for example 500 nm or 1 micron, an additional plasma cleaning step (using an argon/hydrogen mixture, for example) may be used to reduce the thickness of the metal oxide layer 210. The optimal thickness of the oxide can depend on the chemistry of the metal substrate 204 in the case where the oxide is grown from the metal substrate 204. As will be described with reference to figure 2b below, the metal oxide layer 210 can have a lower surface energy than the metal substrate 204, which therefore forms a more effective barrier or mask to prevent or reduce excessive flow-out of flux 208 during the reflow process.

The metal oxide layer 210 can be formed in any known way, including by exposing the metal substrate 204 to heat in an oven, or by any other means. In one example, a copper metal substrate can be exposed to temperatures anywhere in the range of about 50⁰C to 250⁰C, for example 150⁰C to 250⁰C or 175⁰C to 200⁰C, in the presence of air, for a predetermined period in order to provide a copper oxide layer with a desired thickness. Due to the heat processing route used, the oxide layer may have a morphology typical of a thermally grown oxide, that is, of an oxide grown at a temperature that is substantially above room temperature. The oxygen in the air can be considered as a reactive gas. The predetermined period of time can be in the range of 5 to 60 minutes, and in some examples in the range of 15 to 30 minutes. It will be appreciated that for other reactive gases and materials different temperatures and periods of time may be used. Also, the skilled person will appreciate that the temperature used will affect the length of the time period that should be used to obtain a metal oxide layer 210 with the desired properties (such as thickness), and vice versa.

Conveniently, the thickness of the metal oxide layer can be automatically or manually determined by monitoring the colour of the metal oxide layer and comparing it with a colour chart, depending on the material to be oxidized, as is known in the art.

It will be appreciated that the metal-based compound layer does not necessarily have to be an oxide, and that other examples include a metal sulphide layer and a metal nitrite layer. The metal substrate can be exposed to any reactive gas in order to provide the metal-based compound layer.

It will also be appreciated that the metal substrate 204 can comprise any conductive material that is suitable for having a metal-based compound formed on it. Example conductive materials include copper, stainless steel, nickel and any metal that can be oxidised.

After the metal oxide layer 210 has been formed on the metal substrate 204, the flip chip 202 is placed on the metal substrate 204, as shown in figure 2a, such that the solder bump 206 is in contact with a contact region of the metal oxide layer 210. The location of the contact region of the metal oxide layer 210 may correspond to a chip pad on the underlying metal substrate 204 to which the flip chip 202 is to be attached.

The solder bump 206 is then heated such that the contact region of the metal oxide layer 210 dissolves under the influence of the flux 208. The skilled person will appreciate that flux 208 is known to eat away / dissolve metal oxides. As will be appreciated-from the following description of figure 2b, the heating of the solder bump 206 is part of a solder reflow process that results in the solder bump 206 forming an electrical connection between the flip chip 202 and the metal substrate 208.

As shown in figure 2b, the presence of the metal oxide layer 210 can provide a barrier to flux 208 flow out in a direction that is parallel to the plane of the metal substrate 204. This can be due to a decreased surface energy of the metal oxide layer 210 (when compared to the surface energy of the metal substrate without, or with a thinner, metal oxide layer). The decreased surface energy reduces the wetting of the metal oxide layer 210. This can result in a reduction or minimization of flux flow out / deviation (contact pinning), when compared with the result shown in figure 1b. That is, the lateral expansion of the solder 206 and flux 208 in figure 2b (dX2) is less that the lateral expansion (dX) in figure 1b. The resulting surface area of the solder 206 on the metal substrate 204 will therefore also be lower. Furthermore, due to the reduced flux 208 flow-out, the reduction in the height of the flip chip (dZ2) above the metal substrate 204 will also be less than was the case in figure 1 b.

The flux 208 on top of the contact region of the metal oxide layer 210 will eventually break the oxide during the reflow process, which can result in an undistorted interconnection from the metal substrate 204 to the flip chip 202.

Use of the metal oxide layer 210 on the metal substrate 204 can therefore result in better defined flux size control, and can also lead to an enhanced control of tilt, rotation, XY shift and co-planarity of the flip chip 202 that is to be placed on top of the metal substrate 204.

Use of the metal oxide layer 210 can also result in more accurate positioning of the flip chip 202 on the metal substrate 204, due to the reduced flux surface variation during reflow. That is, the centre position of the flux 208 can be better controlled, and therefore a better solder-to-flux match can be achieved. Also, an improved insensitivity for lead-geometry variances can also be realised. Furthermore, the process window for flux application can be increased such that a wider flux size variation can be allowed.

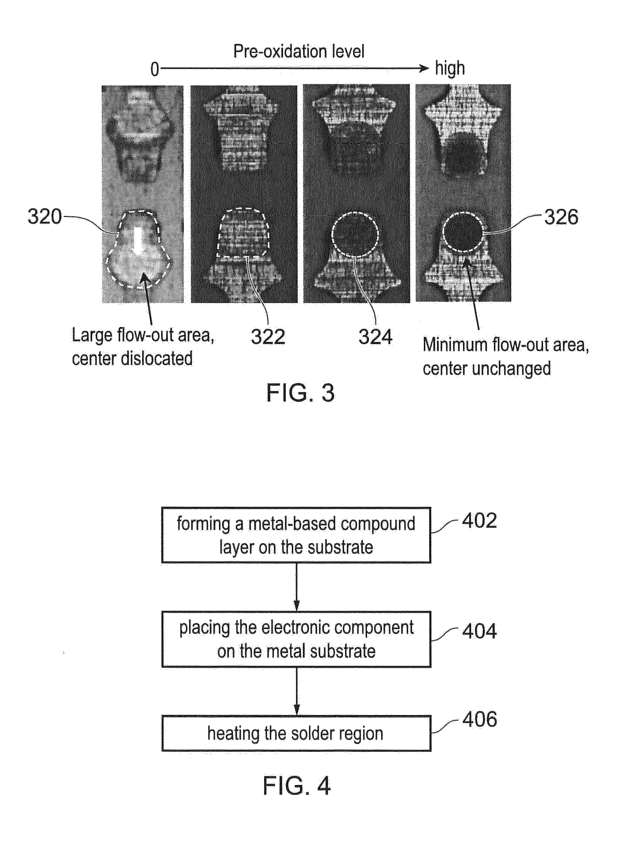

Figure 3 shows four examples of how an amount of flux / solder flow-out varies with a level of oxidation applied to a metal substrate. In each example, a dotted line is shown that defines the outline of the reflowed solder. The level of pre-oxidation increases from left to right in figure 3. It will be appreciated that each of the specific periods of time mentioned below with reference to Figure 3 are examples only, and that different periods can be used for different materials.

The first, leftmost, example in figure 3 shows that, with no pre-oxidation, a relatively large flow-out area 320 occurs, and also shows how the centre of the solder region that is contacting the metal substrate has been displaced / dislocated in relation to the location of the solder bump before reflowing.

The second example in figure 3 shows that, with a small amount of pre-oxidation, the flow-out area 322 has been made smaller when compared with the first example, and also shows that the displacement of the centre of the solder region that is contacting the metal substrate has been reduced. The oxidation of the second example is formed by exposing the metal substrate to an elevated temperature for 2 minutes.

The third example in figure 3 shows that, with a medium amount of pre-oxidation, the flow-out area 324 has been made smaller still, and also shows that the displacement of the centre of the solder region that is contacting the metal substrate has been further reduced. The oxidation of the third example is formed by exposing the metal substrate to an elevated temperature for 15 minutes.

The fourth example in figure 3 shows that, with a high degree of pre-oxidation, the flow-out area 326 generally corresponds with the profile of the solder bump before reflowing, which also results in a small displacement of the centre of the solder region, if there is any displacement at all. The oxidation of the fourth example is formed by exposing the metal substrate to an elevated temperature for 30 minutes.

The examples of figure 3 show how the control of the flux position can be improved by using a pre-oxidation layer. The increased control of flux flow-out and centre position can lead to higher component placement accuracy, which subsequently can leads to a lower likelihood of intermittent contacts between the flip chip and the metal substrate.

Furthermore the flip chip placed on top of the flux-bump combination that has improved homogeneity can show significant enhancement in terms of plan-parallelism with respect to the metal substrate.

Another advantage to using an oxidation layer is an increase of adhesion from the encapsulant towards the metal substrate or leadframe, which can yield better delamination performance of the package, hence providing overall quality improvement. With this enhancement, the manufacturing yield can increase, which can lead to lower overall cost. Such a low cost solution can be further enhanced because expensive solder masks, and the associated processing steps, may not be required, which may otherwise be used to control the solderability performance.

Figure 4 illustrates schematically a method of attaching an electronic component to a metal substrate. The electronic component may be a flip chip, as with the example discussed above. The electronic component comprises an exposed solder region, on which a solder bump with a layer of flux may be provided.

At step 402, the method comprises forming a metal-based compound layer on the substrate. The metal-based compound layer may be an oxide layer, which is formed by exposing the metal substrate to oxygen in air. At step 404, the method comprises placing the electronic component on the metal substrate such that the solder region is in contact with a contact region of the metal-based compound layer. At step 406, the method continues by heating the solder region such that the contact region of the metal-based compound layer dissolves and the solder region forms an electrical connection between the electronic component and the metal substrate.

Use of an oxidation layer, as disclosed herein, can be considered as contrary to the teachings of examples in which metal substrates or leadframes are protected by an Organic Solderability Preservative in order to prevent oxidation, which may be considered as advantageous during storage or transportation, but may be expected to lead to solderability issues. The inventors have found that, surprisingly, use of a suitable oxidation layer can improve the results of a subsequent solder reflow operation.

Also, an oxidation layer that is caused by a reflow oven process may be much thinner than the oxide layers described above, if they are even present at all, because the reflow operation may be performed in a protected atmosphere. If an excessive oxygen level were present during the reflow, then one may expect subsequent failures of the interconnection, hence leading to quality issues. In contrast, examples disclosed herein use a metal-based oxide (or other compound) layer that is present on the metal substrate before reflowing, which provides an alternative to a solder mask, is cost effective, and also provides a reliable, high quality formation of interconnections.

## Claims

1. A method of attaching an electronic component to a metal substrate, wherein the electronic component comprises solder provided on an exposed solder region, the method comprising:
forming a metal-based compound layer on the substrate, wherein the metal-based compound layer has a minimum thickness of 10 nm;
placing the electronic component on the metal substrate such that the solder region is in contact with a contact region of the metal-based compound layer; and
heating the solder region such that the contact region of the metal-based compound layer dissolves and the solder region forms an electrical connection between the electronic component and the metal substrate.

2. The method of claim 1, wherein the metal-based compound layer has a maximum thickness of 50 nm.

3. The method of any preceding claim, wherein the step of forming the metal-based compound layer on the substrate comprises exposing the metal substrate to a reactive gas.

4. The method of claim 3, wherein forming the metal-based compound layer on the substrate comprises exposing the metal substrate to the reactive gas at a temperature in the range of 150⁰C to 250⁰C.

5. The method of claim 3 or claim 4, wherein forming the metal-based compound layer on the substrate comprises exposing the metal substrate to a reactive gas for a predetermined period of time in the range of 5 to 60 minutes.

6. The method of any preceding claim, wherein the exposed solder region comprises a portion of flux.

7. The method of any preceding claim, wherein the electronic component is a flipped component.

8. The method of any preceding claim, wherein the metal-based compound layer has a lower surface energy than the metal substrate.

9. The method of any preceding claim, wherein the metal-based compound layer is a metal oxide layer.

10. The method of claim 9, wherein the metal substrate comprises copper and the metal oxide layer comprises Cu₂O and CuO.

11. Apparatus configured to perform the method of any preceding claim.

12. A substrate for receiving an electronic component having solder provided on an exposed solder region, the substrate comprising:
a metal substrate for electrically connecting to the electronic component; and
a metal-based compound layer over the metal substrate, wherein the metal-based compound layer has a minimum thickness of 10 nm,
wherein the metal-based compound layer is configured to be dissolved upon contact with the solder region when the solder region is molten such that the solder region forms an electrical connection between the electronic component and the metal substrate.

13. The substrate of claim 12, wherein the substrate is a leadframe.

14. The substrate of claim 12 or claim 13, wherein the metal-based compound layer has a lower surface energy than the metal substrate.

15. A flip-chip component comprising the substrate of any one of claims 12 to 14.
